(19) Europäisches Patentamt / European Patent Office / Office européen des brevets

(11) **EP 3 050 319 B1**

(12) **FASCICULE DE BREVET EUROPEEN**

(45) Date de publication et mention
de la délivrance du brevet:
**02.08.2017 Bulletin 2017/31**

(21) Numéro de dépôt: **14784017.7**

(22) Date de dépôt: **26.09.2014**

(51) Int Cl.:
***H04R 3/04*** *(2006.01)*

(86) Numéro de dépôt international:
**PCT/EP2014/070690**

(87) Numéro de publication internationale:
**WO 2015/044385 (02.04.2015 Gazette 2015/13)**

(54) **EQUIPEMENT DE RESTITUTION SONORE AUDIO HAUTE FIDÉLITÉ**

HOCHGENAUE SCHALLWIEDERGABEVORRICHTUNG

HIGH-FIDELITY SOUND REPRODUCTION EQUIPMENT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **26.09.2013 FR 1359302**

(43) Date de publication de la demande:
**03.08.2016 Bulletin 2016/31**

(73) Titulaire: **Devialet**
**75001 Paris (FR)**

(72) Inventeurs:
• **PETROFF, Antoine**
**F-75009 Paris (FR)**
• **CALMEL, Pierre-Emmanuel**
**F-78150 Le Chesnay (FR)**
• **AFRESNE, Jean-Loup**
**F-75004 Paris (FR)**

(74) Mandataire: **Lavoix**
**2, place d'Estienne d'Orves**
**75441 Paris Cedex 09 (FR)**

(56) Documents cités:
**WO-A1-2006/013490     GB-A- 2 324 888**

• **BLASIZZO FABIO ET AL: "Practical Applications
of a Closed Feedback Loop Transducer System
Equipped with Differential Pressure Control",
AES CONVENTION 131; OCTOBER 2011, AES, 60
EAST 42ND STREET, ROOM 2520 NEW YORK
10165-2520, USA, 19 octobre 2011 (2011-10-19),
XP040567575,**

## Description

La présente invention concerne un équipement de restitution sonore, du type comportant :

- une entrée de réception d'un signal d'entrée audio à restituer ;
- un haut-parleur ayant une résistance de moins de 1Ω ;
- une chaîne de traitement et d'amplification comportant :
- un amplificateur propre à exciter le haut-parleur, et
- un étage de correction du signal audio, disposé entre l'entrée et l'amplificateur, lequel étage de correction est propre à simuler des paramètres physiques virtuels du haut-parleur en modifiant les caractéristiques du signal audio fourni à l'amplificateur.

L'équipement de restitution sonore comporte généralement un amplificateur alimentant un système électroacoustique, qui, dans la majorité des cas, est un haut parleur de type électrodynamique (à différencier des haut-parleurs de type électrostatique, piezzo-electrique, à plasma, ...). Dans la suite du texte, le terme de haut-parleur se rapporte à un type électrodynamique. Le rendement de tels haut-parleurs est très faible, celui-ci étant inférieur à 5%. Les pertes sont majoritairement dues à l'échauffement du fil constituant la bobine du haut-parleur.

Les haut-parleurs couramment utilisés dans les équipements ont une résistance de 4 à 8 Ohms.

Il a été envisagé d'utiliser des haut-parleurs avec des résistances inférieures afin d'augmenter le rendement de l'équipement. On constate que leur rendement est surtout augmenté pour les sons aigus et peu pour les sons graves, alors qu'un rendement élevé est recherché principalement pour les sons graves.

En outre, l'utilisation d'un haut-parleur avec une résistance faible typiquement inférieure à 1 Ω conduit à une modification de la réponse en fréquence qui se traduit par une dégradation de la qualité du son restitué, nécessitant un traitement préalable du signal audio adressé à l'amplificateur, pour permettre une écoute satisfaisante du son restitué.

Par ailleurs, il est connu de modifier virtuellement les paramètres d'un haut-parleur, notamment en ajoutant une résistance virtuelle à la bobine du haut-parleur ou un ressort virtuel pour modifier la souplesse, encore appelée compliance, de la partie mobile du haut-parleur. Cette solution est connue notamment du document US 4,118,600.

Cette solution n'est pas mise en oeuvre dans le document US 4,118,600 pour un haut-parleur de faible résistance et ne permet qu'une correction globale d'un haut-parleur insuffisante pour permettre de corriger l'influence de la faible résistance du haut-parleur sur la qualité du son.

L'invention a pour but de proposer un équipement de restitution sonore ayant un haut-parleur de fort rendement et produisant un son de qualité.

A cet effet, l'invention a pour objet un équipement de restitution sonore du type précité, l'étage de correction étant propre à modifier les paramètres physiques virtuels au cours du temps lors du fonctionnement du système de restitution sonore.

Suivant des modes particuliers de réalisation, l'équipement de restitution sonore comporte l'une ou plusieurs des caractéristiques suivantes :

- la chaîne de traitement et d'amplification comporte des moyens de réglage d'au moins un paramètre d'amplification et l'étage de correction est propre à modifier les paramètres physiques virtuels au cours du temps en fonction de l'évolution du paramètre réglé de fonctionnement de l'amplification ;
- l'étage de correction est propre à modifier le signal audio pour simuler une baisse de la résistance électrique du haut-parleur jusqu'à une résistance électrique virtuelle du haut-parleur, lorsque la consigne de volume de la chaîne de traitement et d'amplification dépasse un seuil prédéterminé, selon une courbe prédéterminée ;
- l'étage de correction est propre à modifier les paramètres physiques virtuels au cours du temps en fonction de caractéristiques du signal d'entrée audio ;
- l'étage de correction est propre à modifier le signal audio pour simuler une baisse de la fréquence de résonance du haut-parleur jusqu'à une fréquence de résonance virtuelle du haut-parleur au dessous des fréquences du signal audio à reproduire ;
- l'étage de correction est propre à modifier le signal audio pour simuler un déplacement de la fréquence de résonance du haut-parleur jusqu'à une fréquence de résonance virtuelle du haut-parleur suivant un balayage d'une plage de fréquences prédéterminées suivant une règle de balayage prédéterminée ;
- l'étage de correction est propre à modifier le signal audio pour simuler un déplacement de la fréquence de résonance du haut-parleur jusqu'à une fréquence de résonance virtuelle du haut-parleur en fonction d'une analyse du signal d'entrée audio ;
- l'étage de correction est propre à simuler une modification de la compliance et/ou de la résistance mécanique du haut-parleur et/ou de la masse mobile du haut-parleur pour modifier le signal audio pour simuler un déplacement de la fréquence de résonance du haut-parleur jusqu'à une fréquence de résonance virtuelle du haut-parleur ;
- l'équipement de restitution sonore comporte plusieurs étages de correction propres à modifier les paramètres physiques virtuels en fonction du temps suivant des règles de modification différentes les uns des autres et il comporte des moyens d'agglomération des signaux audio modifiés par chaque étage de correction pour déterminer un signal modifié aggloméré adressé à l'amplificateur.

L'invention sera mieux comprise à la lecture de la description qui va suivre, donnée uniquement à titre d'exemple et faite en se référant aux dessins sur lesquels :

- la figure 1 est une vue schématique d'un équipement de restitution sonore selon l'invention ;
- la figure 2 est une vue schématique du contenu d'un premier processeur de l'équipement de la figure 1 ;
- la figure 3 est un organigramme explicitant un mode de commande de l'équipement selon un premier mode de réalisation ;
- la figure 4 est un graphique illustrant les réponses d'un haut-parleur selon l'invention et d'un haut parleur de l'état de la technique ;
- les figures 5, 6 et 7 sont des organigrammes explicitant des modes de commande de l'équipement des deuxième, troisième et quatrième modes de réalisation ; et
- la figure 8 est une vue schématique d'un autre mode de réalisation d'un équipement selon l'invention.

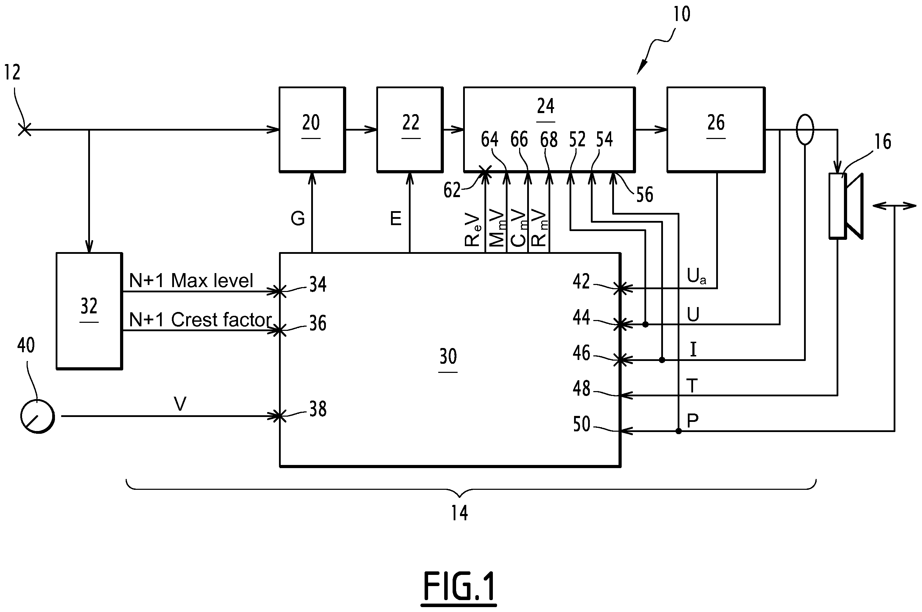

L'équipement de restitution sonore 10 illustré sur la figure 1 comporte une entrée 12 de réception d'un signal audio à restituer, une chaîne 14 de traitement et d'amplification du signal et un haut-parleur 16.

Le haut-parleur est un haut-parleur de type électrodynamique comportant un aimant, une membrane maintenue par une suspension périphérique et une bobine d'excitation de la membrane suspendue par une pièce appelée communément spider. La membrane est mobile sous l'action conjuguée de l'aimant et d'un courant électrique variable traversant la bobine.

Le haut-parleur est logé dans la paroi d'un volume d'air, formant ainsi une enceinte acoustique close, à évent, ou à haut-parleur passif.

Le haut-parleur est caractérisé par les paramètres physiques suivants correspondant aux caractéristiques physiques réelles du haut-parleur sans correction électronique du signal d'excitation :

- l : longueur du fil de la bobine ;
- $R_e$ : résistance de la bobine ;
- Le : inductance de la bobine ;
- $M_m$ : masse mobile du haut-parleur ;
- $C_m$ : souplesse ou compliance (inverse de la raideur du diaphragme et du joint) ;
- $S_d$ : surface du piston formé par la membrane et la partie du joint périphérique ;
- B : champ magnétique de l'aimant ;
- $R_m$ : perte mécanique dans le haut-parleur.

Avantageusement, le haut-parleur est conçu pour que la bobine ait une résistance de moins de 1Ω, celle-ci étant de préférence comprise entre 50 mΩ et 500 mΩ et de manière encore plus avantageuse entre 80 mΩ et 200 mΩ. Pour ce faire, le fil est choisi de gros diamètre et/ou présente une longueur réduite.

La chaîne de traitement et d'amplification 14 comporte un étage de préamplification 20 permettant l'application d'un gain global G au signal d'entrée audio à amplifier. L'étage de préamplification 20 est relié en entrée à l'entrée 12.

La sortie de l'étage de préamplification 20 est reliée à l'entrée d'un égaliseur 22 d'amplitude dépendant de la fréquence, propre à assurer un filtrage suivant une courbe de réponse en fréquence prédéterminée E formant une consigne.

La sortie de l'égaliseur 22 est reliée par un étage 24 de correction permettant de modifier le signal audio à restituer après préamplification et égalisation afin de simuler virtuellement des paramètres physiques modifiés du haut-parleur 16 disposé en aval.

Enfin, la chaîne d'amplification et de traitement 14 comporte un amplificateur de puissance 26 dont l'entrée est reliée en sortie de l'étage de correction 24 et dont la sortie est reliée au haut-parleur 16. L'amplificateur 26 est une source de tension ayant une faible impédance de sortie, inférieure à 10 mΩ. De préférence, l'amplificateur 26 est constitué d'un amplificateur tel que décrit dans la demande de brevet FR 2 873 872.

La chaîne de traitement et d'amplification 14 comporte une unité de commande principale 30 formée d'un processeur de signal numérique assurant le pilotage des étages de préamplification 20, d'égalisation 22 et de correction 24.

L'unité de commande principale 30 est reliée à une unité 32 de prétraitement du signal d'entrée, laquelle est reliée directement à l'entrée 12. L'unité de prétraitement 32 est propre à déterminer en continu le niveau instantané maximal en amplitude du signal acoustique d'entrée à partir d'une analyse fréquentielle multibande. Ce niveau instantané maximal noté *N+1 Max Level* est fourni sur une entrée 34 de l'unité de commande principale 30.

De même, l'unité de prétraitement 32 est propre à fournir, sur une entrée 36 de l'unité de commande principale 30, un facteur de crête du signal d'entrée audio résultant d'une analyse fréquentielle multibande. Ce facteur de crête est noté *N+1 Crest Factor.*

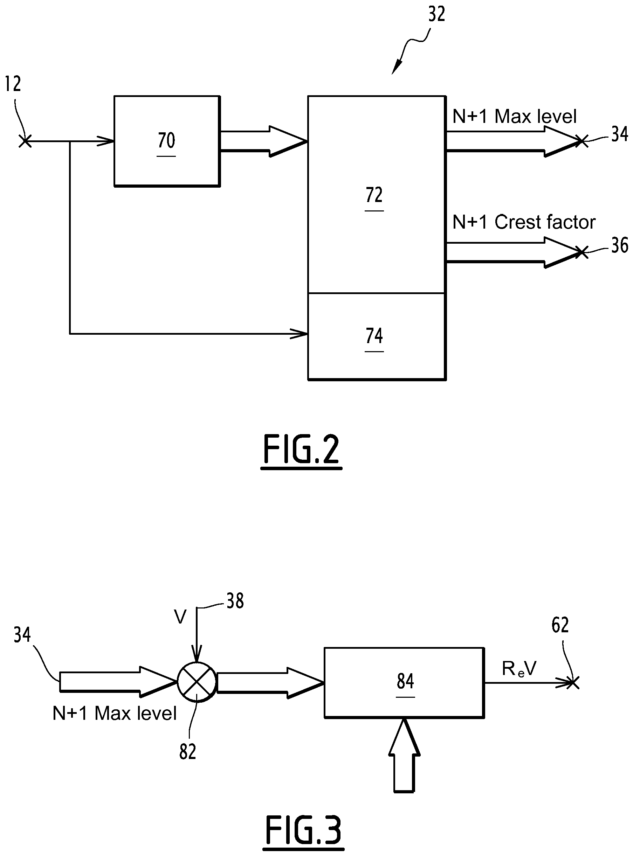

Le détail de l'unité de prétraitement 32 sera décrit en détail au regard de la figure 2.

Sur une entrée 38, l'unité de commande principale 30 est reliée à une interface utilisateur 40, permettant de fixer une consigne de volume V représentative du niveau sonore escompté pour le signal audio restitué par le haut-parleur 16.

Afin d'assurer la commande des étages 20, 22 et 24, l'unité de commande principale 30 reçoit en outre sur une entrée 42, une valeur représentative de la tension $U_a$ d'alimentation de l'amplificateur 26. Elle reçoit également sur des entrées 44 et 46 des valeurs représentatives, respectivement de la tension U et du courant I appliqués aux bornes du haut-parleur 16. Les valeurs reçues sur les entrées 42, 44 et 46 sont mesurées directement sur l'amplificateur 26 ou en sortie de celui-ci par tous moyens connus adaptés.

En outre, l'unité de commande principale 30 reçoit sur des entrées 48 et 50 des valeurs représentatives de l'état du haut-parleur et notamment de la température T de fonctionnement sur l'entrée 48 et de la position P de la membrane du haut-parleur sur l'entrée 50.

Afin de permettre la mise en oeuvre des corrections nécessaires pour modifier les paramètres virtuels du haut-parleur, l'étage de correction 24 reçoit également sur des entrées 52, 54 et 56, les valeurs représentatives des tensions U et courant I appliqués au haut-parleur, ainsi que de la position P courante de la membrane du haut-parleur.

L'unité de commande principale 30 est propre, à partir d'une partie ou de la totalité des valeurs représentatives reçues sur les entrées 34, 36, 38, 42, 44, 46, 48 et 50 à définir des signaux de commande pour les étages 20, 22 et 24.

En particulier, elle est propre à calculer le gain global G appliquée à l'entrée de l'étage de préamplification 20 ainsi que la courbe E d'égalisation de réponse en fréquence appliquée à l'étage d'égalisation 22.

L'étage de correction 24 est propre à corriger la résistance $R_e$ du haut-parleur pour la rendre égale à une valeur virtuelle $R_eV$, la masse mobile $M_m$ pour la rendre égale à une masse mobile virtuelle $M_mV$, la compliance $C_m$ pour la rendre égale à une compliance virtuelle $C_mV$ et la résistance $R_m$ pour la rendre égale à une résistance virtuelle $R_mV$ de la suspension.

Les traitements effectués sur le signal sonore par l'étage de correction 24 sont connus en soi pour modifier virtuellement les paramètres physiques du haut-parleur et ne seront pas décrits plus en détail. Ils sont décrits notamment dans les documents US 4,118,600 et « Practical applications of a Closed Feedback Loop Transducer system equipped with Differential Pressure Control », Audio Engineering Society, Convention Paper 8501, Presented at the 131 st Convention, 2011 October 20-23, New York, NY, USA.

L'unité de commande principale 30 est propre ainsi à adresser sur des entrées 62, 64, 66 et 68 de l'étage de correction 24 des consignes respectivement pour la résistance série virtuelle $R_eV$, la masse mobile virtuelle $M_mV$, la compliance virtuelle $C_mV$ et la résistance virtuelle de la suspension $R_mV$.

L'unité de prétraitement 32 est illustrée en détail sur la figure 2. On retrouve sur cette figure l'entrée 12 pour le signal audio à restituer et les entrées 34, 36 de l'unité de commande principale 30.

L'unité de prétraitement 32 est propre à assurer une analyse du signal d'entrée en séparant le spectre du signal en plusieurs bandes de fréquences prédéfinies.

Elle comporte un module 70 de calcul d'une transformée de Fourier rapide du signal audio dont la sortie est reliée à un analyseur de bande 72. Elle comporte en outre un analyseur 74 de facteur de crête et de détermination du niveau global maximum.

L'analyseur 72 est propre à fournir, à l'entrée 34, N+1 niveaux d'intensité maximaux calculés pour N fréquences prédéterminées du signal et un niveau maximal pour l'ensemble du signal. L'analyseur 74 est propre à fournir à partir du signal audio, sur l'entrée 36, N+1 facteurs de crête pour les mêmes fréquences d'analyse considérées pour le signal global.

Les modes de traitement des signaux mis en oeuvre dans l'unité de commande principale 30 vont maintenant être décrits.

Le gain global G appliqué à l'étage de préamplification 20 est une fonction de la consigne de volume V reçue sur l'entrée 38 comme connue en soi. Elle ne sera pas décrite plus en détail.

La consigne d'égalisation E appliquée à l'égaliseur 22 prend en compte deux composantes.

Comme connue en soi, elle assure d'abord une compensation de l'affaiblissement psycho-acoustique. En fonction de la consigne de volume V reçue sur l'entrée 38, la réponse en fréquence est ajustée pour compenser les pertes en basses fréquences inférieures à 120 Hz et la sensation d'affaiblissement des hautes fréquences supérieures à 5 kHz aux volumes d'écoute faible. L'ajustement de la courbe de réponse en fréquence est réalisé selon des courbes de contours d'égalisation connues.

En outre, la consigne d'égalisation E prend en compte une compensation en réponse en fréquence du réglage des paramètres virtuels du haut-parleur.

Comme connu en soi, certains réglages des paramètres virtuels du haut-parleur changent la réponse en fréquence du système global. La consigne d'égalisation E est fixée pour compenser ces changements et obtenir une réponse en fréquence finale plate pour le système dans une zone de fréquences prédéfinie. La courbe correspondant à la consigne d'égalisation est calculée selon le modèle du haut-parleur virtuel, en calculant la réponse en fréquence complémentaire au résultat obtenu pour la réponse du haut-parleur avec les paramètres virtuels choisis.

L'organigramme de calcul de la consigne de la résistance virtuelle $R_eV$ appliquée sur l'entrée 62 est illustré sur la figure 3.

A partir des niveaux maximaux N+1 Max Level reçus sur l'entrée 34 et de la consigne de volume V reçue sur l'entrée 38, l'unité de commande principale 30 détermine le niveau maximal effectif du signal de sortie de l'amplificateur 26 lors d'une étape 82 puis, calcule, lors d'une étape 84, la valeur de consigne de résistance virtuelle $R_eV$ à appliquer en fonction du niveau maximum réel admissible du haut-parleur, lequel dépend de la fréquence.

La valeur de la résistance virtuelle $R_eV$ est fixée pour minimiser la réponse basse fréquence du système selon le maximum de puissance admissible par le haut-parleur réel, ceci, afin d'abaisser la résistance virtuelle pour les niveaux sonores élevés pour que l'amplificateur puisse être à même de fournir la tension nécessaire pour exciter le haut-parleur. Cette logique de commande conduit à diminuer la tension maximale appliquée au haut-parleur au détriment du niveau relatif du grave par rapport au reste du spectre.

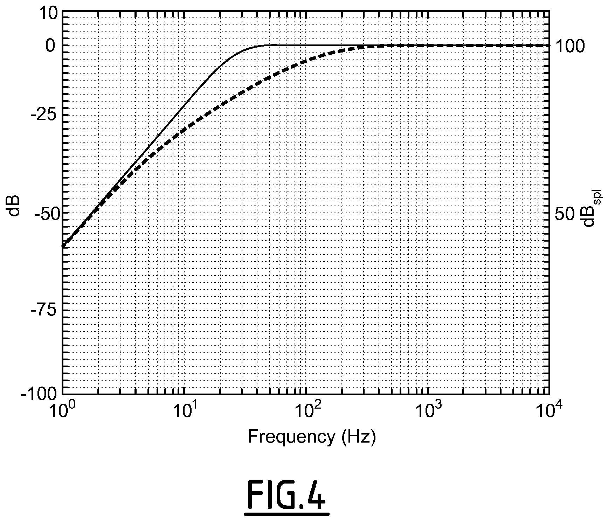

Sur la figure 4 sont illustrées en trait continu la réponse exprimée en décibels en fonction de la fréquence d'un haut-parleur selon l'invention et en trait pointillé la réponse d'un haut-parleur de l'état de la technique.

En pratique, la résistance $R_eV$ est abaissée autour de la fréquence de résonance du haut-parleur, lorsque la consigne de volume V dépasse un seuil prédéterminé.

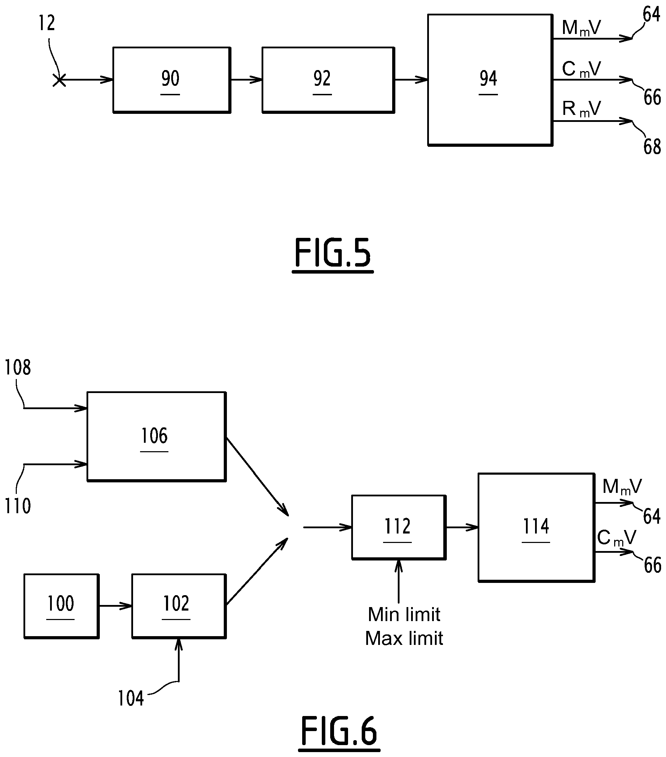

Sur la figure 5 est illustré l'organigramme de calcul en continu des paramètres du haut-parleur virtuel concernant la masse mobile virtuelle $M_mV$, la compliance virtuelle $C_mV$ et la résistance de la suspension $R_mV$.

A partir du signal audio d'entrée à restituer, une transformée de Fourier rapide FFT, ou plus généralement tout autre analyse fréquentielle au cours du temps du signal d'entrée audio, est calculée à l'étape 90 par le bloc 70 de l'unité de prétraitement 32. A l'étape 92, les fréquences les plus basses sont détectées et un calcul est effectué à l'étape 94 pour déterminer l'impédance recherchée du haut-parleur virtuel.

La détermination de l'impédance recherchée est faite en fonction du signal d'entrée pour que la fréquence de résonance du haut-parleur virtuel soit fixée au dessous de la fréquence la plus faible contenue dans le signal d'entré de sorte que l'impédance du haut-parleur virtuel est minimisée sur l'ensemble du spectre qui contient des composantes fréquentielles du signal. La sortie en tension maximale de la source de tension que constitue l'amplificateur 26 est ainsi réduite.

Les paramètres masse mobile virtuelle $M_mV$ et compliance virtuelle $C_mV$ sont calculés et fixés selon la relation suivante définissant la fréquence de résonance virtuelle du haut-parleur à partir de ses paramètres caractéristiques.

$$f_{rv} = f_s \sqrt{1+\alpha} \ [Hz]$$

fréquence de résonance virtuelle
où

$$f_s = \frac{1}{2\pi\sqrt{MmV * CmV}} \ [Hz]$$

fréquence de résonance « intermédiaire » pour le calcul

$$\alpha = \frac{V_{as}}{V_{ab}}$$

$$V_{as} = CmV \, pc^2 S_d^2 \ [m^3]$$

avec c = vitesse du son dans l'air ; p = masse volumique de l'air
et $V_{ab}$ = Volume d'air de la boîte
et $V_{as}$ = Volume d'air équivalent à la raideur de la suspension du haut-parleur
et $MmV$ = Masse mobile mécanique virtuelle
et $CmV$ = Compliance mécanique virtuelle

Suivant un autre mode de réalisation, illustré sur la figure 6, les paramètres du haut-parleur virtuel sont calculés en continu pour assurer un balayage arbitraire d'une plage de fréquence prédéterminée par la fréquence de résonance virtuelle du haut-parleur. L'organigramme de ces calculs est donné sur la figure 6.

La fréquence de résonance virtuelle fluctue entre une valeur limite inférieure min Limit et une fréquence limite maximum max Limit de sorte que l'impédance du haut-parleur virtuel est répartie et l'impédance maximale est alors limitée.

A cet effet, un signal aléatoire est généré à l'étape 100 par l'unité de commande principale 30. Ce signal aléatoire est utilisé pour contrôler le balayage. Ce signal aléatoire est par exemple un bruit aléatoire à spectre large. Le générateur est, en variante, un générateur de bruit avec une fonction de mise en forme fréquentielle pour rendre maximal le rapport signal sur bruit du système.

Le signal issu du générateur de bruit aléatoire est filtré à l'étape 102 en fonction d'un spectre 104 prédéfini. Ce filtre est un filtre de réponse en fréquence en amplitude. La consigne 104 est choisie pour maximiser le rapport signal bruit de l'ensemble du système

Une onde périodique est engendrée par un générateur de forme d'onde à l'étape 106 à partir d'un type 108 de forme d'onde prédéterminé et d'une fréquence 110 de balayage prédéterminée. Entre les fréquences maximale max Limit et minimale min Limit, un balayage de la fréquence de résonance est déterminé à l'étape 112 à partir du signal aléatoire filtré ou de l'onde périodique filtrée.

Le balayage de la fréquence de résonance peut se faire soit par un signal aléatoire (blocs 100, 102, 104) soit par un signal périodique (blocs 106, 108, 110).

Le signal aléatoire est du type bruit large spectre, et peut être filtré pour augmenter le rapport signal bruit du système.

Le signal périodique est de type sinus, triangulaire, carré, sa fréquence est ajustée pour augmenter le rapport signal bruit. Le signal périodique peut encore servir à commuter entre M valeurs correspondant à M HP virtuels selon une séquence définie.

A l'étape 114, l'unité de commande principale 30 calcule l'impédance du haut-parleur virtuel pour que sa fréquence de résonance corresponde à la fréquence issue de l'étape 112. A cet effet, l'étape 114 détermine la masse mobile virtuelle $M_mV$ et la compliance virtuelle $C_mV$ appliquée sur les entrées 64 et 66, notamment à partir de la formule précédente.

Ainsi par exemple, la fréquence de résonance virtuelle fluctue de 20 hertz à 100 hertz par modification des paramètres virtuels du haut-parleur.

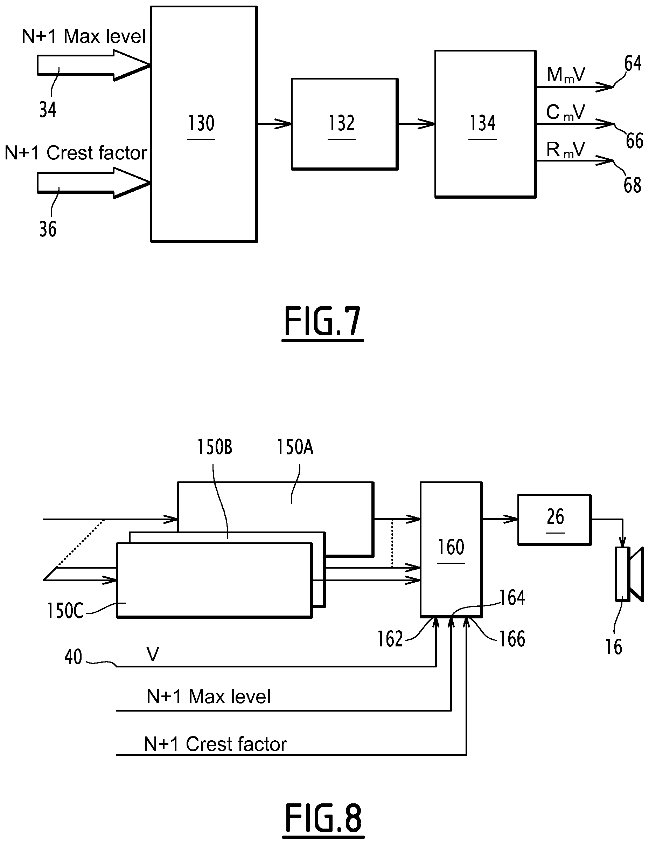

Suivant une variante illustrée sur la figure 7, la variation continue de la fréquence de résonance du haut-parleur virtuel se fait en fonction des fréquences du signal audio à restituer.

A cet effet, l'unité de commande principale 30 considère les niveaux d'intensités maximaux reçus sur l'entrée 34 et les facteurs de crête reçus sur l'entrée 36. Lors d'une étape d'optimisation d'impédance 130, une impédance optimale est calculée.

L'impédance optimale du haut-parleur virtuelle est établie selon l'analyse du signal d'entrée de sorte que l'amplitude de la tension devant être fournie par l'amplificateur de puissance soit maintenue en dessous d'une certaine valeur, tout en permettant un niveau sonore d'écoute élevé.

L'impédance est modifiée avec la prise en compte combinée du balayage de la fréquence de résonance et de la variation de résistance virtuelle. Ces variations sont continues en amplitude ou sont discrètes sur M valeurs présélectionnées qui correspondent à M haut-parleurs virtuels suivant deux modes de réalisation distincts.

La résonance virtuelle est calculée en continu de sorte que la courbe de la moyenne temporelle de l'impédance soit l'enveloppe du module de la transformée de Fourier rapide (FTT) du signal d'entrée.

Suivant un mode particulier de réalisation de l'invention, l'unité de commande principale 30, et l'étage de correction 24 sont remplacés par plusieurs modules de correction comportant chacun une unité de commande principale et un étage de correction, illustrés sur la figure 8 par les références 150A, 150B, 150C. Chaque module est programmé pour assurer une correction du signal audio en fonction d'un haut-parleur virtuel différent. Le signal audio à restituer après préamplification et égalisation est introduit dans chaque module de correction 150A, 150B, 150C.

Les sorties des modules de correction sont reliées à un étage 160 de moyennage et de sommation propre à assurer une combinaison des signaux traités dans les modules de correction 150A, 150B, 150C.

Le signal en sortie de l'étage 160 est adressé à l'étage d'amplification 26, lequel comme précédemment excite le haut-parleur 16.

Les signaux issus des modules 150A, 150B, 150C sont additionnés et moyennés, en tenant compte du niveau de consigne de volume V issu de l'interface 40, et des niveaux d'intensité maximum et des facteurs de crête issus de l'unité de prétraitement 32.

La combinaison des signaux audio traités suivants des haut-parleurs virtuels différents permet un signal sonore restitué de haute qualité puisqu'elle permet de compenser les effets dus à la forme particulière du volume clos dans lequel le haut-parleur est monté.

## Revendications

1. Equipement de restitution sonore (10) comportant :

   - une entrée (12) de réception d'un signal d'entrée audio à restituer ;
   - un haut-parleur (16) ayant une résistance de moins de $1\Omega$ ;
   - une chaîne de traitement et d'amplification (14) comportant :
   - un amplificateur (26) propre à exciter le haut-parleur (16),
   - un étage (24, 30) de correction du signal audio, disposé entre l'entrée (12) et l'amplificateur (26), lequel étage de correction (24, 30) est propre à simuler des paramètres physiques virtuels du haut-parleur (16) en modifiant les caractéristiques du signal audio fourni à l'amplificateur (26),

   **caractérisé en ce que** l'étage de correction (24, 30) est propre à modifier les paramètres physiques virtuels au cours du temps lors du fonctionnement du système de restitution sonore.

2. Equipement (10) de restitution sonore selon la revendication 1, **caractérisé en ce que** la chaîne de traitement et d'amplification (14) comporte des moyens (20, 30, 38, 40) de réglage d'au moins un paramètre (V) d'amplification et **en ce que** l'étage de correction (24, 30) est propre à modifier les paramètres physiques virtuels au cours du temps en fonction de l'évolution du paramètre réglé (V) de fonctionnement de l'amplification.

3. Equipement (10) de restitution sonore selon la revendication 2, **caractérisé en ce que** l'étage de correction (24, 30) est propre à modifier le signal audio pour simuler une baisse de la résistance électrique ($R_e$) du haut-parleur jusqu'à une résistance électrique virtuelle ($R_eV$) du haut-parleur, lorsque la consigne de volume (V) de la chaîne de traitement et d'amplification dépasse un seuil prédéterminé, selon une courbe prédéterminée.

4. Equipement (10) de restitution sonore selon l'une quelconque des revendications précédentes, **caractérisé en ce que** l'étage de correction (24, 30) est propre à modifier les paramètres physiques virtuels au cours du temps en fonction de caractéristiques du signal d'entrée audio.

5. Equipement (10) de restitution sonore selon la revendication 4, **caractérisé en ce que** l'étage de correction (24, 30) est propre à modifier le signal audio pour simuler une baisse de la fréquence de résonance du haut-parleur jusqu'à une fréquence de résonance virtuelle du haut-parleur au dessous des fréquences du signal audio à reproduire.

**6.** Equipement (10) de restitution sonore selon l'une quelconque des revendications 1 à 3, **caractérisé en ce que** l'étage de correction (24, 30) est propre à modifier le signal audio pour simuler un déplacement de la fréquence de résonance du haut-parleur jusqu'à une fréquence de résonance virtuelle du haut-parleur suivant un balayage d'une plage de fréquences prédéterminées suivant une règle de balayage prédéterminée.

**7.** Equipement (10) de restitution sonore selon l'une quelconque des revendications 1 à 3, **caractérisé en ce que** l'étage de correction (24, 30) est propre à modifier le signal audio pour simuler un déplacement de la fréquence de résonance du haut-parleur jusqu'à une fréquence de résonance virtuelle du haut-parleur en fonction d'une analyse du signal d'entrée audio

**8.** Equipement (10) de restitution sonore selon l'une quelconque des revendications 5, 6 et 7, **caractérisé en ce que** l'étage de correction (24, 30) est propre à simuler une modification de la compliance ($C_mV$) et/ou de la résistance mécanique ($R_mV$) du haut-parleur et/ou de la masse mobile ($M_mV$) du haut-parleur pour modifier le signal audio pour simuler un déplacement de la fréquence de résonance du haut-parleur jusqu'à une fréquence de résonance virtuelle du haut-parleur.

**9.** Equipement (10) de restitution sonore selon l'une quelconque des revendications précédentes, **caractérisé en ce qu'**il comporte plusieurs étages de correction (150A, 150B, 150C) propres à modifier les paramètres physiques virtuels en fonction du temps suivant des règles de modification différentes les uns des autres et **en ce qu'**il comporte des moyens (160) d'agglomération des signaux audio modifiés par chaque étage de correction pour déterminer un signal modifié aggloméré adressé à l'amplificateur (26).

**Patentansprüche**

**1.** Schallwiedergabevorrichtung (10), aufweisend:

- einen Empfangseingang (12) eines wiederzugebenden Audio-Eingangssignals,
- einen Lautsprecher (16) mit einem Widerstand unter 1 $\Omega$,
- eine Verarbeitungs- und Verstärkungskette (14), aufweisend:
- einen Verstärker (26), der imstande ist, den Lautsprecher (16) zu erregen,
- eine Korrekturstufe (24, 30) des Audiosignals, die zwischen dem Eingang (12) und dem Verstärker (26) angeordnet ist, wobei die Korrekturstufe (24, 30) imstande ist, die virtuellen physikalischen Parameter des Lautsprechers (16) durch Modifizieren der Merkmale des an den Verstärker (26) gelieferten Audiosignals zu simulieren,

**dadurch gekennzeichnet, dass** die Korrekturstufe (24, 30) imstande ist, die virtuellen physikalischen Parameter im Zeitverlauf während des Betriebs des Schallwiedergabesystems zu verändern.

**2.** Schallwiedergabevorrichtung (10) nach Anspruch 1, **dadurch gekennzeichnet, dass** die Verarbeitungs- und Verstärkungskette (14) Einstellmittel (20, 30, 38, 40) mindestens eines Verstärkungsparameters (V) aufweist und dass die Korrekturstufe (24, 30) imstande ist, die virtuellen physikalischen Parameter im Zeitverlauf in Abhängigkeit von der Entwicklung des eingestellten Verstärkungs-Betriebsparameters (V) zu verändern.

**3.** Schallwiedergabevorrichtung (10) nach Anspruch 2, **dadurch gekennzeichnet, dass** die Korrekturstufe (24, 30) imstande ist, das Audiosignal zu verändern, um ein Absinken des elektrischen Widerstands ($R_e$) des Lautsprechers auf einen virtuellen elektrischen Widerstand ($R_eV$) des Lautsprechers zu simulieren, wenn das Lautstärkesoll (V) der Verarbeitungs- und Verstärkungskette gemäß einer vorbestimmten Kurve einen vorbestimmten Grenzwert überschreitet.

**4.** Schallwiedergabevorrichtung (10) nach einem der vorangehenden Ansprüche, **dadurch gekennzeichnet, dass** die Korrekturstufe (24, 30) imstande ist, die virtuellen physikalischen Parameter im Zeitverlauf in Abhängigkeit von Merkmalen des Audio-Eingangssignals zu verändern.

**5.** Schallwiedergabevorrichtung (10) nach Anspruch 4, **dadurch gekennzeichnet, dass** die Korrekturstufe (24, 30) imstande ist, das Audiosignal zu verändern, um ein Absinken der Resonanzfrequenz des Lautsprechers auf eine virtuelle Resonanzfrequenz des Lautsprechers unterhalb der Frequenzen des wiederzugebenden Audiosignals zu simulieren.

**6.** Schallwiedergabevorrichtung (10) nach einem der Ansprüche 1 bis 3, **dadurch gekennzeichnet, dass** die Korrekturstufe (24, 30) imstande ist, das Audiosignal zu verändern, um eine Verlagerung der Resonanzfrequenz des Lautsprechers auf eine virtuelle Resonanzfrequenz des Lautsprechers nach einer Abtastung eines vorbestimmten Frequenzbereichs gemäß einer vorbestimmten Abtasteinstellung zu simulieren.

7. Schallwiedergabevorrichtung (10) nach einem der Ansprüche 1 bis 3, **dadurch gekennzeichnet, dass** die Korrekturstufe (24, 30) imstande ist, das Audiosignal zu verändern, um eine Verlagerung der Resonanzfrequenz des Lautsprechers auf eine virtuelle Resonanzfrequenz des Lautsprechers in Abhängigkeit einer Analyse des Audio-Eingangssignals zu simulieren.

8. Schallwiedergabevorrichtung (10) nach einem der Ansprüche 5, 6 und 7, **dadurch gekennzeichnet, dass** die Korrekturstufe (24, 30) imstande ist, eine Veränderung der Compliance ($C_mV$) und/oder des mechanischen Widerstands ($R_mV$) des Lautsprechers und/oder der mobilen Masse ($M_mV$) des Lautsprechers zu simulieren, um das Audiosignal zu verändern, um eine Verlagerung der Resonanzfrequenz des Lautsprechers auf eine virtuelle Resonanzfrequenz des Lautsprechers zu simulieren.

9. Schallwiedergabevorrichtung (10) nach einem der vorangehenden Ansprüche, **dadurch gekennzeichnet, dass** sie mehrere Korrekturstufen (150A, 150B, 150C) aufweist, die imstande sind, die virtuellen physikalischen Parameter in Abhängigkeit von der Zeit gemäß voneinander unterschiedlichen Veränderungsregeln zu verändern und dass sie Konzentrationsmittel (160) der von jeder Korrekturstufe veränderten Audiosignale aufweist, um ein konzentriertes verändertes Signal zu bestimmen, das an den Verstärker (26) geschickt wird.

**Claims**

1. A piece of sound reproduction equipment (10) including:

   - an input (12) for receiving an audio input signal to be reproduced;
   - a loudspeaker (16) with a resistance of at least $1\Omega$;
   - a processing and amplification chain (14) including:
   - an amplifier (26) able to energize the loudspeaker (16),
   - a stage (24, 30) for correction of the audio signal, positioned between the input (12) and the amplifier (26), which correction stage (24, 30) is able to simulate virtual physical parameters of the loudspeaker (16) by modifying the characteristics of the audio signal provided to the amplifier (26),

   **characterized in that** the correction stage (24, 30) is able to modify the virtual physical parameters over time during operation of the sound reproduction system.

2. The piece of sound reproduction equipment (10) according to claim 1, **characterized in that** the processing and amplification chain (14) includes means (20, 30, 38, 40) for adjusting at least one amplification parameter (V) and **in that** the correction stage (24, 30) is able to modify the virtual physical parameters over time depending on the time-dependent change of the adjusted parameter (V) for operation of the amplification.

3. The piece of sound reproduction equipment (10) according to claim 2, **characterized in that** the correction stage (24, 30) is able to modify the audio signal in order to simulate a lowering of the electric resistance ($R_e$) of the loudspeaker down to a virtual electric resistance ($R_eV$) of the loudspeaker, when the set volume (V) value of the processing and amplification chain exceeds a predetermined threshold, according to a predetermined curve.

4. The piece of sound reproduction equipment (10) according to any of the preceding claims, **characterized in that** the correction stage (24, 30) is able to modify the virtual physical parameters over time depending on the characteristics of the audio input signal.

5. The piece of sound reproduction equipment (10) according to claim 4, **characterized in that** the correction stage (24, 30) is able to modify the audio signal in order to simulate lowering of the resonance frequency of the loudspeaker as far as a virtual resonance frequency of the loudspeaker below the frequencies of the audio signal to be reproduced.

6. The piece of sound reproduction equipment (10) according to any of claims 1 to 3, **characterized in that** the correction stage (24, 30) is able to modify the audio signal for simulating displacement of the resonance frequency of the loudspeaker as far as a virtual resonance frequency of the loudspeaker following a sweep of a range of predetermined frequencies according to a predetermined sweeping rule.

7. The piece of sound reproduction equipment (10) according to any of claims 1 to 3, **characterized in that** the correction stage (24, 30) is able to modify the audio signal in order to simulate a displacement of the resonance frequency of the loudspeaker as far as a virtual resonance frequency of the loudspeaker depending on an analysis of the audio input signal

8. The piece of sound reproduction equipment (10) according to any of claims 5, 6 and 7, **characterized in that** the correction stage (24, 30) is able to simulate a modification of the compliance ($C_mV$) and/or of the mechanical resistance ($R_mV$) of the loudspeaker and/or of the mobile mass ($M_mV$) of the loudspeaker in order to modify the audio signal for simulating a displacement of the resonance frequency of the loudspeaker as far as a virtual resonance frequency of the loudspeaker.

9. The piece of sound reproduction equipment (10) according to any of the preceding claims, **characterized in that** it includes several correction stages (150A, 150B, 150C) able to modify the virtual physical parameters over time according to modification rules different from each other and **in that** it includes means (160) for agglomerating audio signals modified by each correction stage in order to determine an agglomerated modified signal addressed to the amplifier (26).

FIG.1

32

12

70

N+1 Max level

34

72

N+1 Crest factor

36

74

## FIG.2

38

V

34

62

N+1 Max level

84

$R_eV$

82

## FIG.3

FIG.4

12

90

92

94

M$_m$V → 64

C$_m$V → 66

R$_m$V → 68

## FIG.5

108

106

110

100 → 102

104

112

Min limit
Max limit

114

M$_m$V → 64

C$_m$V → 66

## FIG.6

N+1 Max level

34

130

132

134

$M_mV$  64

$C_mV$  66

$R_mV$  68

N+1 Crest factor

36

## FIG.7

150B  150A

150C

160

26

16

164

162  166

40  V

N+1 Max level

N+1 Crest factor

## FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4118600 A

- FR 2873872

**Littérature non-brevet citée dans la description**

- Practical applications of a Closed Feedback Loop Transducer system equipped with Differential Pressure Control. 131 st Convention. Audio Engineering Society, 20 Octobre 2011